# EUROPEAN PATENT APPLICATION

(11) **EP 2 075 854 A2**
(43) Date of publication of application: **01.07.2009**
(21) Application number: 08172922.0
(22) Date of filing: 24.12.2008
(51) Int. Cl.: H01L 31/101

(54) **Photodetection semiconductor device, photodetector, and image display device**

(30) Priority: 25.12.2007 JP 2007332336
(71) Applicant: Seiko Instruments Inc., Chiba-shi, Chiba (JP)
(72) Inventor: Omi, Toshihiko c/o Seiko Instruments Inc, Chiba-shi Chiba (JP); Nakata, Taro c/o Seiko Instruments Inc, Chiba-shi Chiba (JP)
(74) Representative: Cloughley, Peter Andrew

(57) **Abstract**

Shields that transmit light to be detected and have conductivity are disposed on light receiving surfaces of photodiodes (1 and 2) to prevent electric charges from being induced to the photodiodes (1 and 2) by electromagnetic waves entered from an external. Two kinds of filters having light transmittance depending on a wavelength of light are disposed on the light receiving surfaces of the photodiodes (1 and 2), respectively, to take a difference between their spectral characteristics. The shield and filter may be made of, for example, polysilicon or a semiconductor thin film of a given conductivity type, and may be readily manufactured by incorporating those manufacturing processes into a semiconductor manufacturing process.

## Description

The present invention relates to a photodetection semiconductor device, a photodetector, and an image display device, and, for example, relates to a device for measuring lightness of the outside by using a light receiving element.

Illuminance of the outside is measured by an illuminometer to control an object based on a measured value such that the brightness of a backlight of a liquid crystal display screen attached on a cellular phone is adjusted according to the lightness of the outside.

A light receiving element constructed from a semiconductor device such as a photodiode that converts the intensity of received light (light intensity) into a corresponding current is used in an illuminometer.

Since silicon (Si), which is a material of the light receiving element, has, however, a peak of sensitivity in an infrared light, a difference in current between light receiving elements having different spectral characteristics is made to obtain a desired spectral characteristic in order to realize a sensor for a visible to ultraviolet light.

For example, the light receiving elements having different spectral characteristics are appropriately combined to detect the light in the visible range, thereby enabling realization of the spectral characteristic close to a human eye.

A "semiconductor photodetector" disclosed in JP 01-207640 A proposes a technology for obtaining a desired spectral characteristic by combination of two light receiving elements together as described above.

In this technology, two n-type layers different in depth are formed on a p-type substrate to form two photodiodes different in spectral characteristic, and a difference in current between those photodiodes is taken to detect a light in an ultraviolet region.

However, in the conventional art, the detected value may be affected by an incident electromagnetic wave to the photodiode from the outside.

In light of the foregoing circumstances, it is an object of the present invention to provide a photodetection semiconductor device and a photodetector which are capable of reducing an influence of the electromagnetic wave.

In order to achieve the above-mentioned objects, according to a first aspect of the present invention, there is provided a photodetection semiconductor device, including: a first light receiving element having a semiconductor substrate of a first conductivity type and a first conductive layer formed of a second conductivity type semiconductor disposed with a given depth from a surface of the semiconductor substrate; a second light receiving element having the semiconductor substrate and a second conductive layer formed of the second conductivity type semiconductor disposed with a depth the same as or deeper than the given depth from the surface of the semiconductor substrate and having a spectral characteristic different from a spectral characteristic of the first light receiving element; and an electromagnetic wave shield layer transmitting light and having a conductivity disposed on a surface of the first conductive layer and a surface of the second conductive layer, in which a light intensity is detected from a difference between electric charges accumulated in the first light receiving element and electric charges accumulated in the second light receiving element.

According to a second aspect of the present invention, there is provided the photodetection semiconductor device according to the first aspect of the present invention, in which the electromagnetic wave shield layer is formed of the first conductivity type semiconductor.

According to a third aspect of the present invention, there is provided the photodetection semiconductor device according to the first aspect of the present invention, in which the electromagnetic wave shield layer is formed of polysilicon.

According to a fourth aspect of the present invention, there is provided a photodetector, including: accumulating means for accumulating electric charges generated respectively in the first light receiving element and the second light receiving element of the photodetection semiconductor device in each of them and connected to the photodetection semiconductor device according to the first, second, or third aspect of the present invention; difference acquiring means for acquiring a difference between the accumulated electric charges; and difference output means for sending the acquired difference.

According to a fifth aspect of the present invention, there is provided an image display device, including: the photodetector according to the fourth aspect of the present invention; image display means for displaying an image; lightness determining means for determining lightness of an outside with the aid of an output from the photodetector; and brightness adjusting means for adjusting brightness of the image display means according to the determined lightness.

According to the present invention, the provision of the electromagnetic wave shield layer enables an influence of the electromagnetic wave to be reduced.

Embodiments of the present invention will now be described by way of further example only and with reference to the accompanying drawings, in which:
FIG. 1 is a diagram illustrating an example of a structure of a semiconductor device that forms photodiodes;
FIG. 2 is a graph schematically illustrating a spectral characteristic of the photodiodes;
FIG. 3 is a diagram for describing a configuration of a photodetector;
FIGS. 4A and 4B are schematic graphs for describing saturation of outputs of the photodiodes;
FIG. 5 is a diagram illustrating a configuration of a photodetector according to a modification;
FIG. 6 is a diagram illustrating a configuration of a photodetector according to another modification;
FIG. 7 is a diagram illustrating a configuration of a photodetector according to yet another modification;
FIGS. 8A and 8B are diagrams illustrating a structure of a semiconductor device according to another embodiment;
FIGS. 9A and 9B are diagrams illustrating a structure of a semiconductor device according to a modification;
FIGS. 10A to 10C are diagrams illustrating a structure of a semiconductor according to another embodiment;
FIGS. 11A and 11B are diagrams illustrating a structure of a semiconductor device according to a modification;
FIGS. 12A and 12B are diagrams illustrating configurations of a digitizing circuit and a digital output photodetection circuit;
FIGS. 13A to 13D are timing charts of the digitizing circuit;
FIGS. 14A and 14B are diagrams illustrating configurations of a digitizing circuit and a digital output photodetection circuit according to another embodiment; and
FIGS. 15A to 15D are timing charts of the digitizing circuit according to the another embodiment.

### (1) Outline of Embodiments

### Embodiment of Photodetector

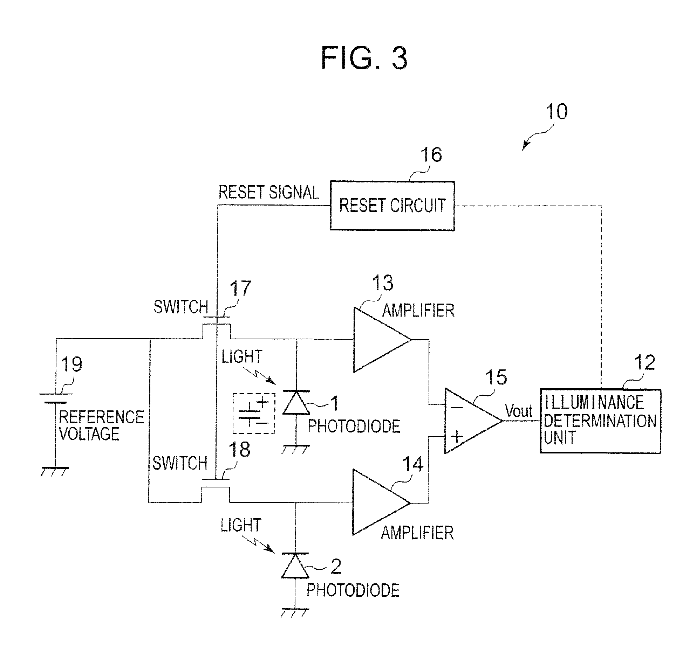

A photodetector 10 (FIG. 3) detects light intensity of a desired wavelength region according to a difference in electric charges accumulated in photodiodes 1 and 2 having different spectral characteristics in a given period of time while making cathode terminals in an open end state.

Since electric charges are accumulated in the photodiodes 1 and 2, even if a photocurrent is small, it is possible to obtain the electric charges required for detection through accumulation of the photocurrent. Hence it is also possible to achieve downsizing and high detection performance of the semiconductor device with the photodiodes 1 and 2.

Further, it is possible to obtain a wide dynamic range by varying an electric charge accumulation time according to the light intensity, to suppress electric power consumption by intermittently driving elements required for difference detection at the time of difference detection, or to reduce flicker by averaging the output.

### Embodiment of Photodetection Semiconductor Device

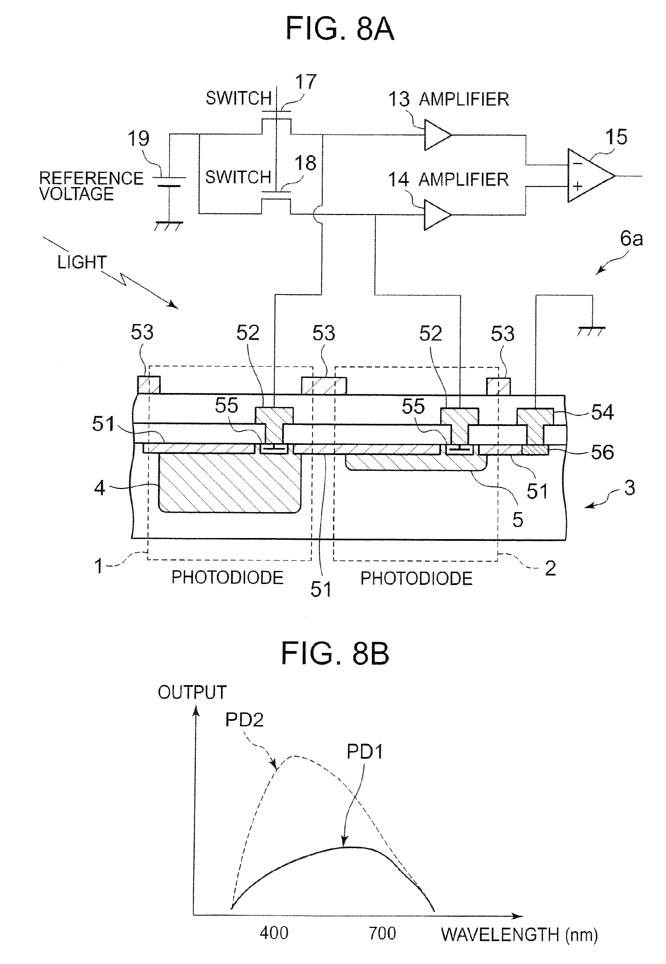

A conductive shield that allows penetration of a light to be detected is disposed on the light receiving surface of the photodiodes 1 and 2 (FIG. 8A) to suppress induction of the electric charges in the photodiodes 1 and 2 by the electromagnetic wave coming from the outside.

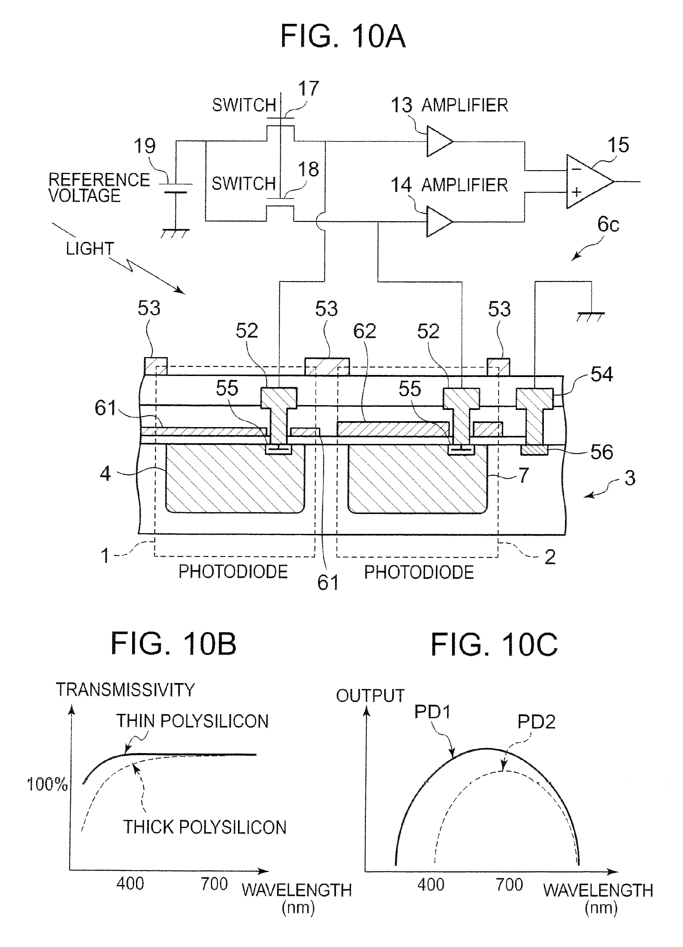

Further, two kinds of filters (FIG. 10A) whose light transmittance depends on the wavelength are disposed on the light receiving surfaces of the photodiodes 1 and 2, respectively, thereby enabling a difference to occur between the spectral characteristics thereof.

The shield and the filter may be formed of, for example, polysilicon or a given conductive semiconductor thin film, whose manufacture processes is incorporated into the semiconductor manufacturing process, permitting manufacturing of the semiconductor device without difficulty.

### Embodiment of Digital Output Photodetection Circuit

The amount of electric charges accumulated in the photodiodes 1 and 2 is compared with clocks to generate a count value corresponding to the amount of electric charges so as to convert the amount of accumulated electric charges into a digital value.

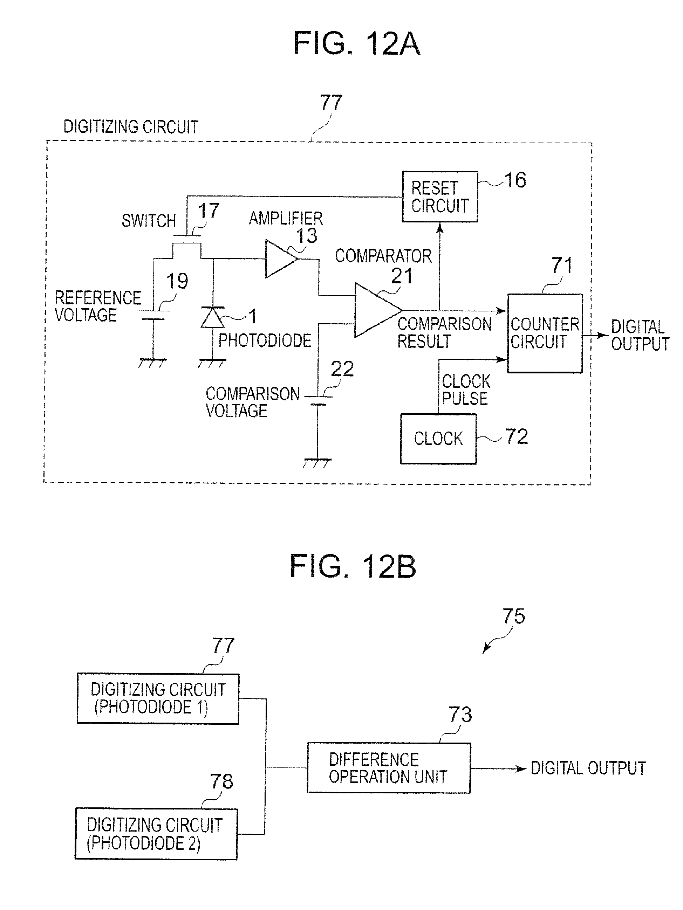

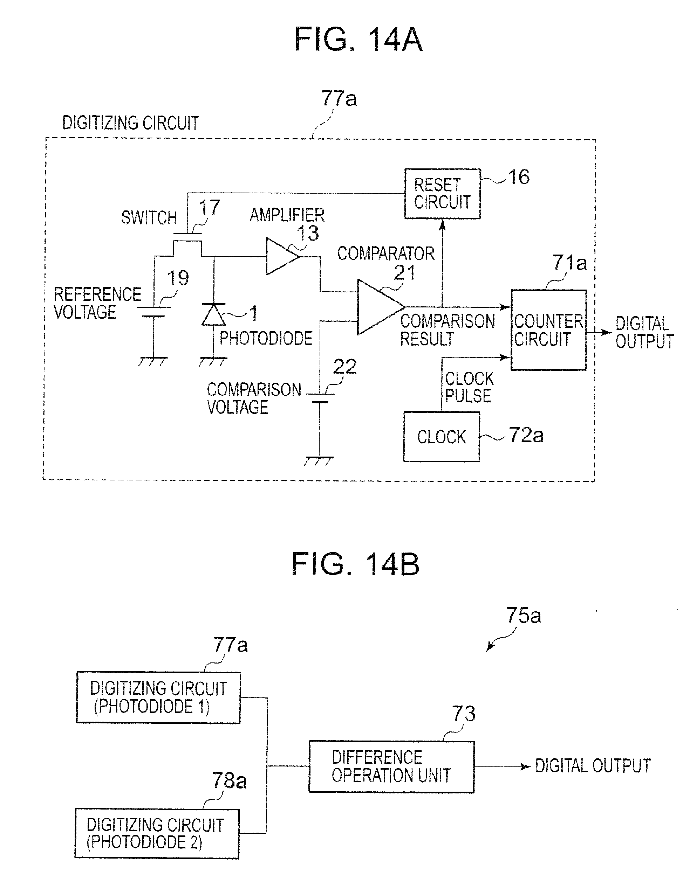

Two methods are provided to achieve the above-mentioned operation, in which the number of clock pulses is counted until a change in the accumulated electric charges reaches a given amount (FIGS. 12A and 12B), and in which the cycle number of repetitions of the accumulation and reset of electric charges in the photodiodes 1 and 2 is counted within a given reference pulse period (FIGS. 14A and 14B).

Then, the digitized outputs of the photodiodes 1 and 2 are calculated to permit an output of the resultant difference in a digital value.

In the above-mentioned methods, the digital value can be obtained with a simple combination of a counter, a clock and the like, and there is no necessity of using a complicated logic such as an A/D converter.

### (2) Details of Embodiments

Embodiments consist of "photodetector", "photodetection semiconductor device", and "digital output photodetection circuit", which are described in order below.

In the following description, a description is given using photodiodes as light receiving elements, but other elements such as phototransistors can also be employed.

### Embodiments of Photodetector

A conventional photodetector uses a difference between currents generated in photodiodes to detect the light intensity. However, in order to improve a signal-to-noise (SN) ratio and obtain a sufficient sensitivity, it is necessary to increase the current in the light receiving element, which is achieved by increasing an area of the light receiving element.

Accordingly, improvement in the sensitivity requires increase in size of a semiconductor device and an IC chip on which the semiconductor device is formed, leading to a difficult problem in downsizing of the sensor.

In the embodiment, consequently, electric charges generated in the photodiodes and accumulated for a given period of time are amplified by an amplifier to take a difference therebetween.

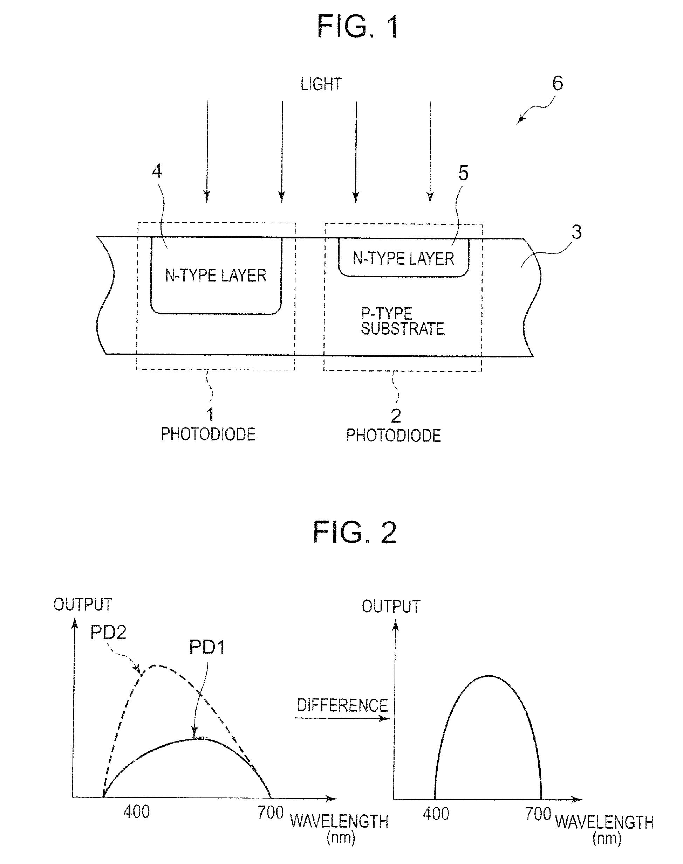

FIG. 1 is a diagram illustrating an example of a semiconductor device on which photodiodes used in this embodiment are formed.

A semiconductor device 6 is made of, for example, single crystal silicon, and includes a p-type substrate 3 that is formed to have p-type conductivity, and n-type layers 4 and 5 which are n-type regions.

The n-type layers 4 and 5 are formed with given depths from a front surface of the p-type substrate 3, and the n-type layer 4 reaches a position deeper than the n-type layer 5.

Then, the n-type layer 4 and the p-type substrate 3 constitute a photodiode 1, and the n-type layer 5 and the p-type substrate 3 constitute a photodiode 2.

When incident light falls on a light receiving surface (front surface) of the semiconductor device 6, electrons and holes are generated in a p-n junction by the aid of a light energy, which may be obtained as a voltage or a current output.

Since the light transmittance of the n-type layer, through which the light penetrates until the light reaches the p-n junction after entering the light receiving surface, depends on the light wavelength and the thickness of the n-type layer, the photodiodes 1 and 2 exhibit different spectral characteristics.

Here, the "spectral characteristic" means a correspondence relationship (dependency relationship) between the output of the photodiode and the wavelength of the incident light, which may be also called "spectral sensitivity" or "spectral sensitivity characteristic".

As described above, the photodiode 1 operates as a first light receiving element which generates electric charges by the received light, and the photodiode 2 operates as a second light receiving element which generates electric charges by the received light, and has a spectral characteristic different from that of the first light receiving element.

FIG. 2 shows a graph schematically illustrating the spectral characteristics of the photodiode 1 (PD1) and the photodiode 2(PD2). Note that since the graph in FIG. 2 is schematically drawn to describe the concept, precise illustration is necessarily not made.

The vertical axis represents an output (current, voltage, or the like) which is generated by the photodiodes, and the horizontal axis represents the wavelength of incident light. The light intensity of incident light is assumed to be constant.

In this example, a peak wavelength of the spectral sensitivity characteristic of the photodiode 2 locates on a shorter wavelength side of the photodiode 1, the sensitivity at the peak wavelength of the photodiode 2 is made larger than that of the photodiode 1, and the sensitivity in an infrared region (whose wavelength is longer than about 70 [nm]) of the photodiode 2 is identical with that of the photodiode 1.

Accordingly, the sensitivity in the visible light region can be obtained by taking a difference between the photodiodes 1 and 2 to cancel the output from the infrared region.

Since the spectral characteristics of the photodiodes 1 and 2 can be adjusted by the thicknesses of the n-type layers, individually, a desired spectral characteristic can be obtained by appropriately determining the spectral characteristics of the photodiodes 1 and 2 to take a difference between the outputs.

FIG. 3 shows a diagram for describing the configuration of the photodetector 10 according to the embodiment.

The photodetector 10 is employed, for example, as an illuminometer, which detects illuminance of the outside, and used to adjust the brightness of a backlight for a liquid crystal display screen of a cellular phone.

The photodiodes 1 and 2 are photodiodes that are different in spectral characteristic from each other, and are configured such that differences between the outputs show a spectral characteristic similar to the spectral characteristic of a human eye.

An anode terminal of the photodiode 1 is grounded, and a cathode thereof is connected to an amplifier 13 and also connected to a DC power supply 19 through a switch 17.

The switch 17 is formed of a switching element such as a transistor, and turns on/off the connection of the photodiode 1 and the DC power supply 19 according to a reset signal from a reset circuit 16.

The amplifier 13, which is configured by an amplifier circuit such as an operational amplifier, detects a voltage at the cathode terminal of the photodiode 1 to amplify and output the voltage to a difference circuit 15.

The amplifier 13 has, for example, an input impedance of infinity so as to prevent a current flow from the photodiode 1, and can amplify the current without affecting a voltage developed in the photodiode 1.

The DC power supply 19 is formed of, for example, a constant voltage circuit, and sets a cathode terminal of the photodiode 1 to a reference voltage when the switch 17 turns on.

On the other hand, when the switch 17 turns off, the cathode terminal is electrically put into an open end state (floating state), and electric charges corresponding to the light intensity are accumulated in the photodiode 1.

In this case, since the photodiode 1 is reverse-biased by means of the DC power supply 19, the voltage at the cathode terminal decreases due to electrons generated in the photodiode 1.

As described above, the amount of electric charges accumulated in the photodiode 1 can be detected as a voltage. Then, the rate of the voltage decrease is inversely proportional to a rate at which electrons are generated, that is, the light intensity.

When the switch 17 again turns on, the electric charges that have been accumulated in the photodiode 1 are reset to an initial state, and the voltage at the cathode terminal becomes a reference voltage.

A switch 18, the photodiode 2, and an amplifier 14 have an identical configuration with the switch 17, the photodiode 1, and the amplifier 13, respectively.

The reset circuit 16 transmits the reset signal to the switches 17 and 18 at regular intervals, and turns on and off those switches 17 and 18 at the same time.

Then, upon turning on the switches 17 and 18, the reset circuit 16 resets the voltages at the cathode terminals of the photodiodes 1 and 2 to the reference voltage (that is, resets the electric charges that have been accumulated in the photodiodes 1 and 2 to an initial value), and starts accumulation of the electric charges in the photodiodes 1 and 2 upon turning off the switches 17 and 18.

As described above, the reset circuit 16 and the switches 17 and 18 operate as accumulating means which puts the terminals of the first light receiving element and the second light receiving element into the open end state to accumulate the electric charges that are generated in the light receiving elements, and also operate as reset means which connects given electrodes (cathode terminals in this case) of the first light receiving element and the second light receiving element to a given constant voltage source (DC power supply 19) to reset the electric charges which have been accumulated in the light receiving element.

The difference circuit 15 receives the voltages which have been sent from the amplifier 13 and the amplifier 14 to generate a difference therebetween, and sends the difference to an illuminance determination unit 12.

As described above, the difference circuit 15 operates as difference acquiring means that acquires a difference between the electric charges which have been accumulated in the first light receiving element (photodiode 1) and the second light receiving element (photodiode 2), and also operates as difference output means that sends the acquired difference (to the illuminance determination unit 12).

Further, the difference circuit 15 acquires a difference in the accumulated electric charges therebetween due to a voltage difference between the given electrodes (between cathodes) of the first light receiving element (photodiode 1) and the second light receiving element (photodiode 2).

The illuminance determination unit 12 samples and acquires the difference of the voltages which is sent from the difference circuit 15 in synchronization to the reset signal of the reset circuit 16 (for example, immediately before reset), and determinates the illuminance of the outside.

The illuminance determination unit 12 memorizes, for example, a correspondence between the difference and the illuminance, thereby enabling determination of the illuminance of the outside.

The determination unit 12 operates as lightness determining means that determines the lightness of the outside by the aid of the output of the photodetector 10 (in this example, a configuration of the photodetector 10 except for the illuminance determination unit 12).

Further, although not shown, the illuminance determination unit 12 is connected to, for example, a brightness adjustment unit that adjusts the brightness of a backlight of the liquid crystal display device, and the brightness adjustment unit is configured to adjust the brightness of the backlight of the liquid crystal display device according to the result of determination from the illuminance determination unit 12.

In this example, the liquid crystal display device operates as image display means that displays an image, and the brightness adjustment unit operates as brightness adjusting means that adjusts the brightness of the image display means according to the illuminance that is determined by the illuminance determination unit 12.

The operation of the photodetector 10 configured as described above is described.

### First, the operation of the photodiode 1 is described.

When the reset circuit 16 turns on the switch 17, the cathode terminal of the photodiode 1 becomes the reference voltage due to the DC power supply 19 and the electric charges which have been accumulated in the photodiode 1 are reset to the initial value.

Subsequently, when the reset circuit 16 turns off the switch 17, the photodiode 1 is disconnected from the DC power supply 19, and, due to the infinite input impedance of the amplifier 13, the cathode terminal is put into an open end state in which the cathode terminal is electrically disconnected from the circuit.

In that case, as illustrated in the dashed-line box, the photodiode 1 has a p-n junction surface operating as a capacitor, and accumulates electric charges generated by light. Then, having been reverse-biased by the DC power supply 19, the voltage at the cathode terminal decreases at a rate corresponding to the light intensity due to the electric charges which are accumulated in the photodiode 1.

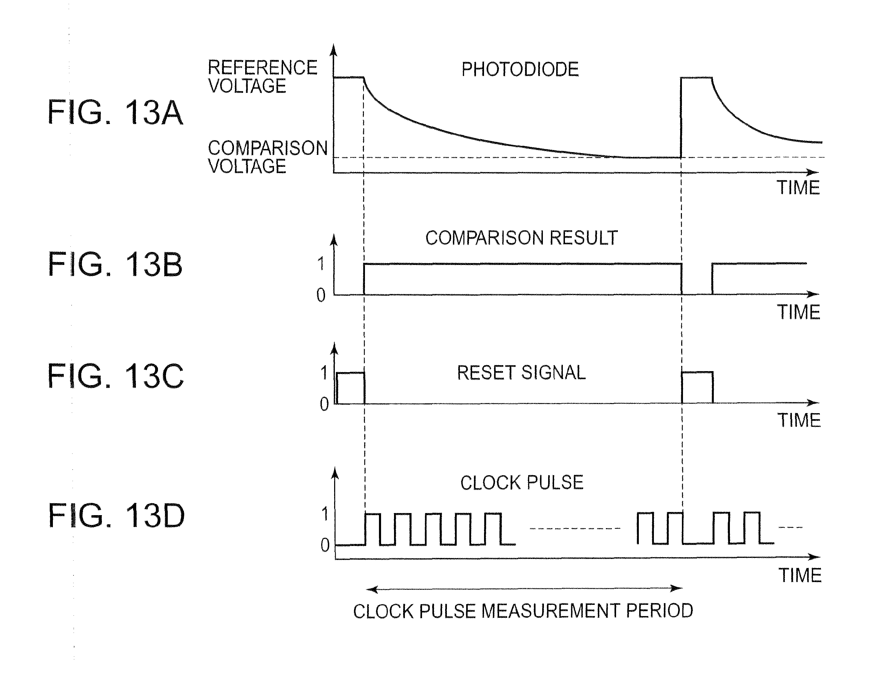

Since the reset circuit 16 repeats the on/off operation of the switch 17, the voltage at the cathode terminal of the photodiode 1 repeats a cycle consisting of the reference voltage (electric charge reset), reduction of the voltage (electric charge accumulation), which is illustrated in FIG. 13A.

Similarly, the voltage at the cathode terminal of the photodiode 2 repeats a cycle consisting of the reference voltage, reduction of the voltage in synchronization with the photodiode 1. However, the rates at which the voltage decreases are different due to the different spectral characteristics of photodiodes 1 and 2.

Accordingly, after the outputs of the photodiodes 1 and 2 have been amplified, a difference between those outputs is taken by the difference circuit 15. Then, the difference becomes a difference between the electric charges that have been accumulated in the photodiodes 1 and 2, that is, a value corresponding to the illuminance.

Thus, when the illuminance determination unit 12 detects the output of the difference circuit 15 at a given period of time after reset (for example, immediately before subsequent reset), the illuminance determination unit 12 can detect the difference between the electric charges that have been accumulated in the photodiodes 1 and 2 between the reset and the detection, permitting determination of the illuminance.

As described above, in the photodetector 10, the outputs of the two light receiving elements (photodiodes 1 and 2) different in spectral characteristic are connected to the input of the amplifier, and the light receiving elements may be put into a floating state.

Further, the photodetector 10 has a mechanism which resets the electric charges of the light receiving elements at given intervals by using the DC power supply 19 and the reset circuit 16, enabling accumulation of the electric charges in the light receiving elements at the given intervals and output of a difference of the signals amplified by the amplifiers.

And, a desired spectral characteristic can be provided by obtaining an output difference between the voltages of the two light receiving elements different in spectral characteristic.

Since an input voltage Vin of the amplifier is determined from a total capacitance C of the light receiving element and an electric charge Q which are generated by the light illuminance by an equation Vin = Q/C, the sensor sensitivity can be enhanced by reducing the capacitance of the light receiving element.

This fact means that the sensitivity of the sensor improves along with the downsizing of the sensor, which is an advantageous property from the viewpoint of downsizing the sensor.

The photodetector 10 is configured to, for example, measure the illuminance inside a room, but this embodiment is one example, and the spectral characteristics of the photodiodes 1 and 2 may be appropriately determined so as to be used as an ultraviolet sensor.

### First Modification

Receiving intense light causes rapid accumulation of the electric charges in the photodiodes 1 and 2, and hence large illuminance saturates the outputs of the photodiodes 1 and 2 before the detection of the output from the difference circuit 15 by the illuminance determination unit 12, thereby making incorrect measurement of a precise value.

In this modification, then, the reset interval is shortened against intense receiving light to shorten the accumulation period for the electric charge to prevent the saturation of the photodiodes 1 and 2, thereby permitting widening of the dynamic range.

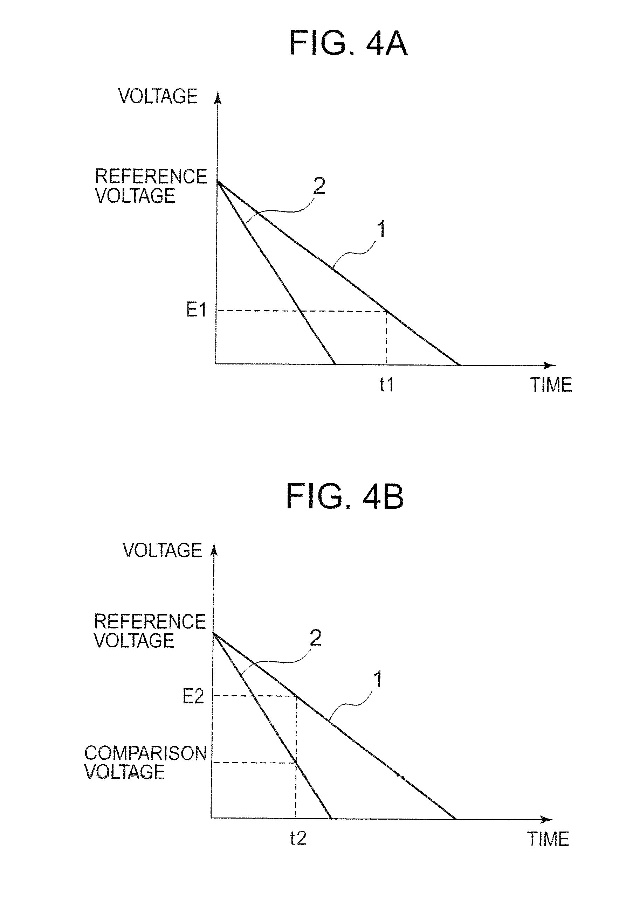

FIG. 4A is a schematic graph for describing a case in which the output of the photodiode 2 is saturated at the time of reset.

First, when the switches 17 and 18 are turned off after connecting the photodiodes 1 and 2 to the DC power supply 19 to set the voltage at the cathode terminals to the reference voltage, the voltage at the cathode terminals begin to decrease as illustrated in FIG. 4A. In this example, it is assumed that the voltage of the photodiode 2 decreases faster than that of the photodiode 1 due to a difference in spectral characteristics.

In FIG. 4A, the output of the photodiode 2 saturates before reaching a reset time t1 due to large light intensity. When the illuminance determination unit 12 is assumed to detect the output of the difference circuit 15 immediately before reset, a detection value corresponding to the light intensity cannot be obtained in the photodiode 2 at the reset time t1 due to the saturation of the output though a voltage E1, which is corresponding to the light intensity, is detected in the photodiode 1.

In this modification, as illustrated in FIG. 4B, a reset is made when the voltage across the photodiode having larger voltage drop (photodiode 2 in this case) reaches a given reference voltage of comparison (hereinafter, referred to as "comparison voltage").

In an example of FIG. 4B, the reset is made at a time t2 when the photodiode 2 reaches the comparison voltage, and in this case, the voltage across the photodiode 1 becomes E2. Both of the photodiodes 1 and 2 can thus output the voltages corresponding to the light intensities.

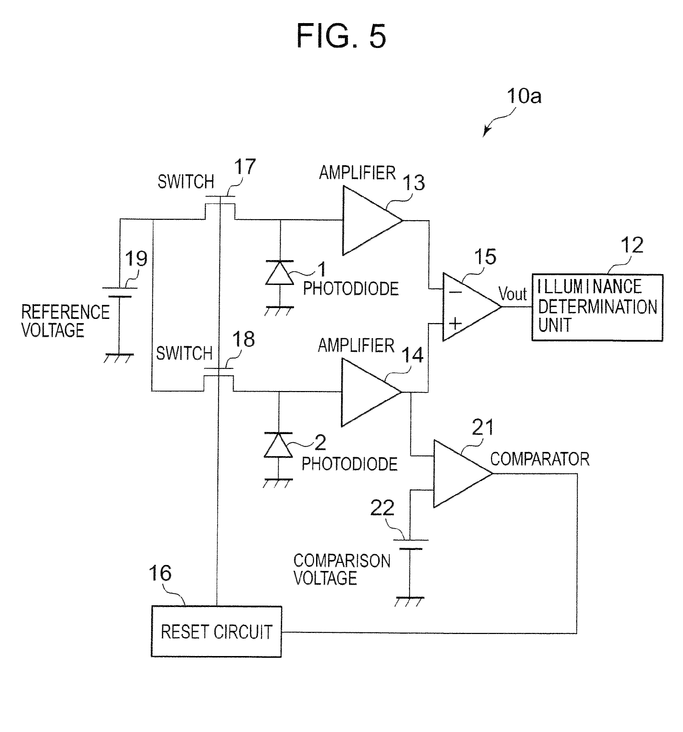

FIG. 5 is a diagram illustrating a configuration of a photodetector 10a which conducts the above-mentioned operation. The same configurations as those of FIG. 3 are denoted by identical reference numerals, and their description is simplified or omitted.

The photodetector 10a further includes a DC power supply 22 and a comparator 21 in addition to the configuration of the photodetector 10.

The DC power supply 22 is a constant voltage source that provides the comparator 21 with a comparison voltage. In this example, the DC power supply 22 is configured to have an output of a fixed comparison voltage, or may be configured to select the comparison voltage suitable for the light intensity with a variable comparison voltage.

The comparator 21 supplies "1", for example, when the output of the amplifier 14 is larger than the comparison voltage, and supplies "0" when the comparison voltage is equal to or smaller than the comparison voltage. Thus, the comparator 21 compares the voltage across the photodiode 2 which has been amplified by the amplifier 14 with the comparison voltage, and supplies its comparison result as a digital signal.

The reset circuit 16 monitors the output of the comparator 21, and resets the switches 17 and 18 when the reset circuit 16 detects that the voltage across the amplifier 14 decreases down to the comparison voltage (in the above-mentioned example, the reset circuit 16 detects that the output changes from "1" to "0"), thereby permitting the photodetector 10a to reset the electric charges before saturation of the outputs from the photodiodes 1 and 2.

Further, the illuminance determination unit 12, for example, memorizes the correspondence among the voltage difference between the amplifiers 13 and 14, the reset interval and the light intensity to determine the illuminance according to the output from the difference circuit 15.

The comparator 21 and the DC power supply 22 operate as changing means that changes a period of time during which the accumulating means accumulates the electric charges according to the light intensity.

As described above, in this modification, there is provided a function of changing the period during which the light receiving element accumulates the electric charge according to the illuminance (more specifically, the accumulation period is shortened by a large illuminance), thereby making it possible to realize the illuminance sensor with a wide dynamic range (which is capable of measuring wide range of illuminance).

### Second Modification

The amplifiers 13 and 14 and the difference circuit 15 of the photodetector 10 (FIG. 3) receive the power supply from a power supply (not shown) to conduct an amplification process and a difference process.

In this modification, the amplifiers 13 and 14 and the difference circuit 15 are not always driven, but are intermittently driven only when the illuminance determination unit 12 detects the difference between the photodiodes 1 and 2 for determination (that is, when needed) to save the power consumption.

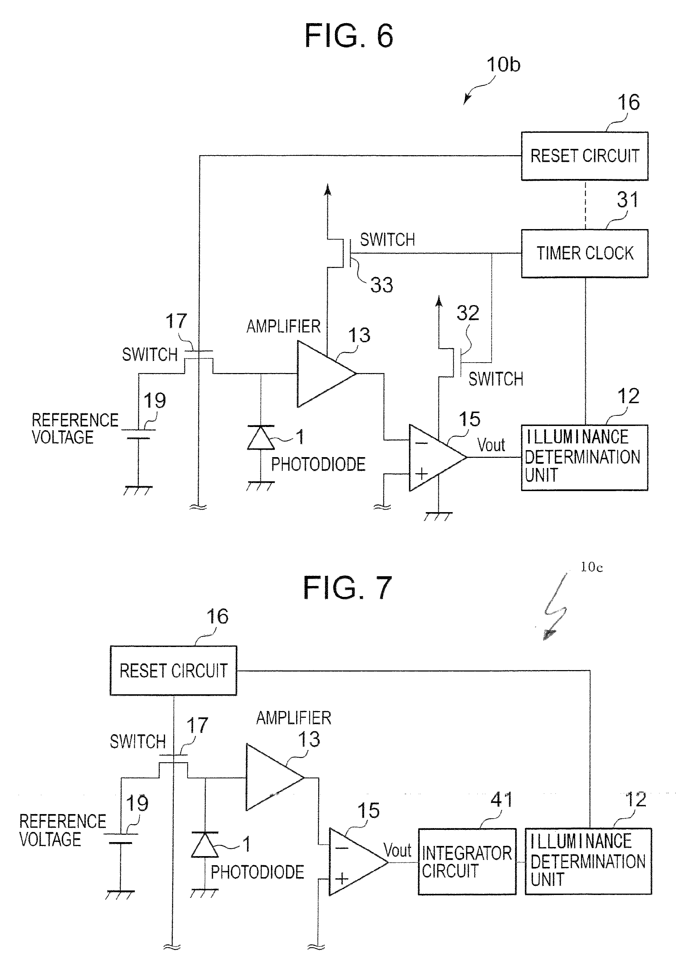

FIG. 6 is a diagram illustrating the configuration of a photodetector 10b according to this modification. It should be noted that the same configurations as those of FIG. 3 are denoted by identical reference numerals, and their description is simplified or omitted. Further, for simplification of the drawing, the photodiode 2, the amplifier 14, and the switch 18 are omitted.

A photodetector 10b further includes a timer 31 and switches 32 and 33 in addition to the configuration of the photodetector 10.

The switch 32 and the switch 33 are formed of switching elements such as transistors, and turn on/off power supply to the difference circuit 15 and the amplifier 13, respectively. Further, although not shown, the amplifier 14 is provided with a similar switch.

The timer 31 is a clock that turns on/off the switches 32 and 33 at given time intervals, and also supplies the clock to the illuminance determination unit 12.

The timer 31 may be formed to, for example, generate a clock of a low cycle by dividing an internal clock by means of a frequency divider circuit.

The illuminance determination unit 12 operates synchronously with the clock which is supplied by the timer 31, and detects the output of the difference circuit 15 at timing when the switches 32 and 33 turn on.

The reset circuit 16 operates in synchronism with the timer 31, and resets the electric charges of the photodiodes 1 and 2, for example, immediately after detection by the illuminance determination unit 12.

As described above, the timer 31, the switches 32 and 33, and a switch (not shown) disposed in the amplifier 14 function as driving means that drives the difference output means at timing when the difference output means outputs the difference.

As described above, the photodetector 10b intermittently operates the amplifiers 13 and 14 and the difference circuit 15 only when the illuminance determination unit 12 detects and determines the difference between the outputs of the photodiodes 1 and 2, thereby permitting reduction of the power consumption as compared with that of the photodetector 10.

### Third Modification

This modification is made to reduce an influence of flicker in a light source.

A light source such as a fluorescent lamp may repeat tuning on and off or flicker in a cycle of 50 [Hz] or 60 [Hz].

In the photodetector 10 (FIG. 3), when the light intensity of the light source in which flicker occurs is measured, the measured value of the illuminance differs depending on a position of an instant in a flicker at which the illuminance determination unit 12 detects the difference.

For example, a cellular phone is frequently used in a room, which is illuminated with a fluorescent lamp, and thus it is necessary to measure the light intensity appropriately under the presence of flicker.

In this modification, the difference between the photodiodes 1 and 2 is thus time-averaged to reduce the influence of flicker.

FIG. 7 is a diagram illustrating a configuration of a photodetector 10c that is designed with a countermeasure against flicker. The same configurations as those of FIG. 3 are denoted by identical reference numerals, and their description is simplified or omitted. Further, for simplification of the drawings, the photodiode 2, the amplifier 14, and the switch 18 are omitted.

A photodetector 10c is configured to include an integrator circuit 41 between the difference circuit 15 and the illuminance determination unit 12 in the configuration of the photodetector 10, and integrates the output of the difference circuit 15 with the integrator circuit 41.

The integrator circuit 41 integrates the output of the difference circuit 15 over time, and supplies the resultantly obtained integration value. The integration value is a cumulative value of a plurality of detection values, and thus variation in the difference is reduced by averaging.

As described above, the integrator circuit 41 functions as reducing means that reduces the variation occurring in the difference of the difference circuit 15 when the light intensity that is issued by the light source varies due to flicker.

The illuminance determination unit 12 operates in association with the reset signal of the reset circuit 16, and detects the integration value at an instant when the reset circuit 16 resets a given number of times after the integrator circuit 41 starts integration.

When the illuminance determination unit 12 makes the detection, initialization such as setting of the integration value of the integrator circuit 41 to zero is conducted.

As described above, in this embodiment, even when the output of the difference circuit 15 is varied by flicker, the variation of the output is averaged by adding a plurality of measured values by the integrator circuit 41, thereby permitting supply of the detection value in which the influence of flicker has been suppressed.

In this modification, integration is used to suppress the influence of flicker. Alternatively, there may be applied any method that may reduce the variation of the detection value due to flicker.

The embodiment and the modifications described above may obtain the following advantages.
(1) The electric charges which are generated by light which is detected by the photodiodes 1 and 2 are accumulated.
(2) The difference is made between the electric charges generated in the two photodiodes 1 and 2 having different spectral characteristics to obtain the desired spectral characteristic.
(3) The amount of electric charges generated in the photodiodes 1 and 2 is detected by the voltage.
(4) The light intensity is measured by the electric charges accumulated in the photodiodes 1 and 2, and thus no large light-induced current is required, permitting downsizing of the photodiodes 1 and 2.
(5) The capacitance of the photodiodes 1 and 2 is reduced to obtain a large sensitivity, and hence the area of the photodiodes 1 and 2 is reduced, permitting realization of a low-cost sensor.
(6) The reset interval of electric charges that have been accumulated in the photodiodes 1 and 2 is changed according to the intensity of the outside light, thereby enabling realization of a wide dynamic range.
(7) The amplifiers 13 and 14 and the difference circuit 15 are driven only when necessary, thereby permitting reduction in the power consumption.
(8) The influence caused by flicker is reduced by the integrator circuit 41.
(9) In the integrated circuit (IC) including the two light receiving elements having different spectral characteristics, the amplifiers connected to the outputs of the light receiving elements, and the mechanism of resetting the electric charges of the light receiving elements in a given cycle after having been brought into the floating state, the electric charges are accumulated in the light receiving elements in the given cycle, and the difference between the signals that have been amplified by the amplifiers is supplied, permitting realization of a small-sized illuminance sensor.

### Embodiment of Photodetection Semiconductor Device

The photodetector 10 may use the semiconductor device 6 with the structure illustrated in FIG. 1, alternatively a semiconductor device with a different structure may be used.

In the following, a description is given of a semiconductor device applicable to the photodetector 10 according to another embodiment.

### First Embodiment of Photodetection Semiconductor Device

The photodetector 10 accumulates the electric charges in the photodiodes 1 and 2 to measure the illuminance. For that reason, there is a fear that the influence of electromagnetic wave from the outside affects the measurement result as compared with a case in which the difference of the current is made in the conventional art.

Under the above-mentioned circumstances, in this embodiment, a thin film electrode having an optical transparency is disposed on the photodiode, and the photodiodes are shielded from electromagnetic noises (for example, commercial electric waves or electromagnetic noises generated from electric equipment) from the outside.

FIG. 8A is a diagram illustrating a structure of a semiconductor device 6a according to this embodiment.

The semiconductor device 6a is a photodetection semiconductor device in which n-type layers 4 and 5 different in the thickness are formed on the p-type substrate 3 as in the semiconductor device 6.

In this example, the photodiode 1 functions as a first light receiving element that is formed of a semiconductor substrate (p-type substrate 3) formed of a first conductivity type (p-type in this example) semiconductor and a first conductive layer (n-type layer 4) formed of a second conductive type (n-type in this example) semiconductor which is formed with a given depth from a surface of the semiconductor substrate, and the photodiode 2 functions as a second light receiving element formed of a semiconductor substrate (p-type substrate 3) and a second conductive layer (n-type layer 5) formed of a second conductivity type semiconductor which is formed with a depth shallower than the given depth from the surface of the semiconductor substrate.

Thin film p-type layers 51 are formed on upper surfaces of the n-type layers 4 and 5.

Since the p-type layers 51 have a transparency with respect to a detecting light, and are electrically conductive, each of the p-type layers 51 permits transmission of a light for illuminance measurement, but shields the electromagnetic waves which enter the light receiving surface from the outside.

The p-type layer 51 may be formed through a normal semiconductor manufacturing process in manufacturing of the semiconductor device 6a, and hence the p-type layer 51 may be formed at low costs.

As described above, electromagnetic wave shield layers (p-type layers 51) that transmit light and have the conductivity are formed on the surfaces of the first conductive layer (n-type layer 4) and the second conductive layer (n-type layer 5)

The p-type layers 51 may more effectively exhibit the shield function by grounding.

Aluminum wirings 52 that are connected to the n-type layers 4 and 5 are connected to the n-type layers 4 and 5 through n+ layers 55 with high concentration of n-type, respectively.

Wiring through-holes are provided in the p-type layers 51, and the aluminum wirings 52 are formed in the through-holes.

Further, the p-type substrate 3 is connected to an aluminum wiring 54 through a p+ layer 56 with high concentration of p-type, and is grounded.

Light shielding aluminums 53 are formed on the light receiving surface in regions in which no photodiode is formed, and shield the incidence of light.

FIG. 8B is a schematic graph illustrating an outline of the spectral characteristics of the photodiode 1 (PD1) and the photodiode 2 (PD2).

The photodiode 1 with the deeper n-type layer 4 is higher in sensitivity of the infrared light side than the photodiode 2.

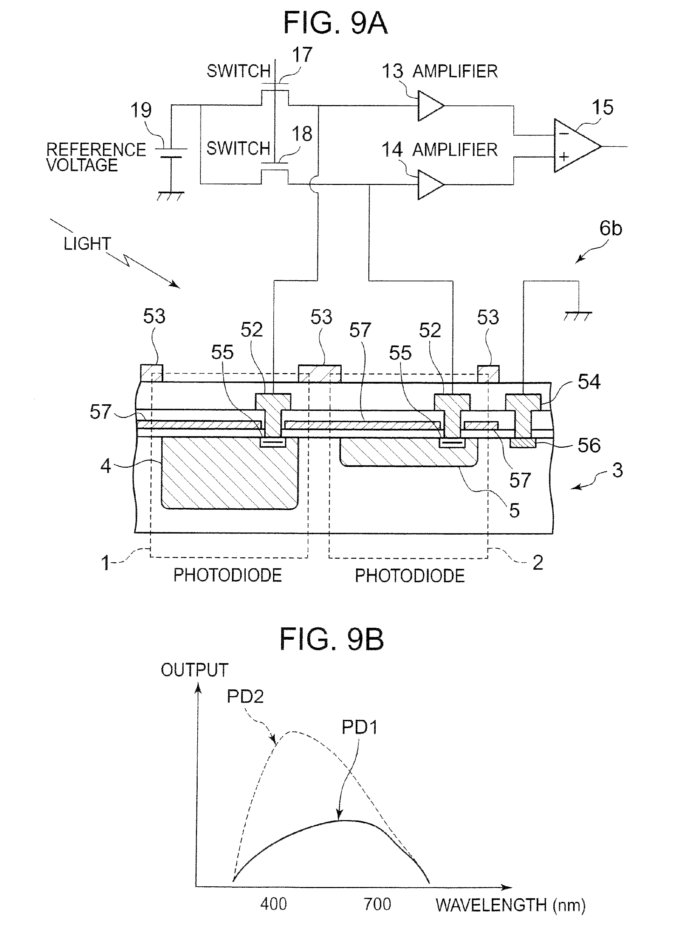

FIG. 9A is a diagram illustrating a structure of a semiconductor device 6b according to a modification of this embodiment.

The semiconductor device 6b includes thin-film polysilicon layers 57. Each of the polysilicon layers 57 also may transmit the light to be detected, and shield the electromagnetic wave. Further, the polysilicon layer 57 may be readily formed through the normal semiconductor manufacturing process.

Other configurations are identical with those of the semiconductor device 6a, and the spectral characteristic is also identical with that of the semiconductor device 6a as illustrated in FIG. 9B.

As described above, in this embodiment as well as the modification, the thin film electrode having the permeability (for example, polysilicon of about 1,000 [Å]) is disposed on the light receiving element, and may shield the electromagnetic noises from the outside.

### Second Embodiment of Photodetection Semiconductor Device

In this embodiment, the depth of the n-type layer is identical, and a filter having the spectral characteristic is disposed on the light receiving surface to thereby provide a difference in the spectral characteristic between the photodiodes 1 and 2.

FIG. 10A is a diagram illustrating a structure of a semiconductor device 6c according to this embodiment.

An n-type layer 7 of the photodiode 2 is formed with the same depth as that of the n-type layer 4. For that reason, the spectral characteristics caused by the depth of the n-type layer of the photodiode 1 and the photodiode 2 are identical with each other.

On the other hand, a polysilicon layer 61 is formed on an upper surface of the n-type layer 4, and a polysilicon layer 62 that is thicker than the polysilicon layer 61 is formed on an upper surface of the n-type layer 7. Other configurations are identical with those of the semiconductor device 6.

As described above, in the semiconductor device 6c, a filter layer (polysilicon layer 61) whose light transmittance depends on the wavelength of light is formed on the surface of the first conductive layer (n-type layer 4), and a filter layer (polysilicon layer 62) having a dependency different from that of the first filter layer is formed on the surface of the second conductive layer (n-type layer 7).

Polysilicon has the characteristic that attenuates (cuts) a light in a range of from blue to ultraviolet as the thickness thereof becomes larger as illustrated in FIG. 10B. In other words, a filter different in the transmittance according to the wavelength of light is formed.

For that reason, the polysilicon layer 62 is low in the transmittance of light in the range of from blue to ultraviolet as compared with the polysilicon layer 61. As a result, the photodiode 1 and the photodiode 2 exhibit the different spectral characteristics.

As described above, polysilicon different in film thickness may be arranged on the light receiving element to thereby provide the different spectral characteristics.

FIG. 10C is a schematic graph illustrating the spectral characteristics of the photodiodes 1 and 2, and the photodiode 2 is lower in the sensitivity on the shorter wavelength side of light compared with the photodiode 1.

In this embodiment, the thin film of polysilicon is used as the filter, but, for example, the thin film of the p-type layer may be used as the filter.

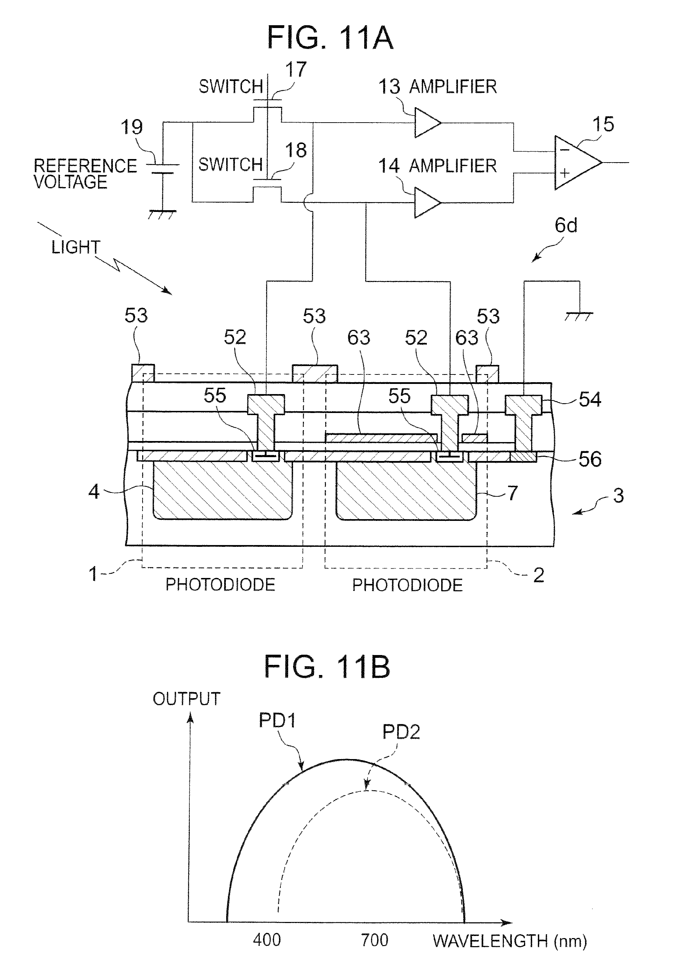

FIG. 11A is a diagram illustrating a structure of a semiconductor device 6d according to a modification of this embodiment. In this example, no polysilicon layer is formed on the light receiving surface of the photodiode 1, and a polysilicon layer 63 is formed on the light receiving surface of the photodiode 2.

Likewise, in this case, light attenuates in the range of from blue to ultraviolet among the light that is received by the photodiode 2, and hence the same characteristic as that of the semiconductor device 6c is obtained as illustrated in FIG.11B.

In the above-mentioned description, in the semiconductor devices 6c and 6d, the depths of the n-type layers 4 and 7 are identical with each other, but may be different from each other.

Both of the thicknesses of the filter and the n-type layer are adjusted to enable the more diverse spectral characteristics to be realized.

Further, the polysilicon layer has the conductivity and the shield function of the electromagnetic wave as well, and hence it is possible to realize both of the spectral characteristic of the photodiodes and the shield of the electromagnetic wave.

The embodiment and the modification described above may obtain the following advantages.
(1) The electromagnetic waves that enter the light receiving surface may be attenuated or cut by the thin film having the conductivity.
(2) With the provision of the filters different in the transmittance according to the wavelength of light on the light receiving surface, the photodiodes may provide the spectral characteristics.
(3) The filter has the conductivity, and thus the filter may shield the electromagnetic wave at the same time.

### Embodiment of Digital Output Photodetection Circuit

The outputs of the photodiodes 1 and 2 are analog values, and what utilizes the light intensity detected by the photodiodes is a digital device such as a cellular phone.

For that reason, it is necessary to convert the detection values obtained by the photodiodes 1 and 2 into digital signals.

In the case where the outputs of the photodiodes are converted into the digital signals, the conversion into the digital signals has been executed by means of an A/D converter in the conventional art.

As to the above-mentioned technology, there is proposed "photosensor circuit" disclosed in, for example, JP 11-304584 A.

In this technology, a plurality of reference voltages for detecting the outputs of the photodiodes are provided, and any one of the reference voltages is selected according to an input range of the A/D converter.

However, the use of the A/D converter makes the scale of logic larger, resulting in a correspondingly larger circuit scale. For that reason, there arises such a problem that the size of the IC chip increases, a demand for downsizing is not met, and the manufacture costs increase.

Under the above-mentioned circumstance, in this embodiment, there is provided a digital output photodetection circuit that requires no A/D converter large in the circuit scale with the aid of the characteristic that the photodiodes 1 and 2 accumulate electric charges.

### First Embodiment of Digital Output Photodetection Circuit

In this embodiment, a period of time during which voltages of the photodiodes 1 and 2 drop is measured by the number of reference pulses, thereby digitizing the light intensity.

FIG. 12A is a diagram illustrating a configuration of a digitizing circuit 77 that digitizes the output of the photodiode 1.

The digitizing circuit 77 is configured by using the same elements as those of the photodetector 10a illustrated in FIG. 5. The same elements as those of FIG. 5 are denoted by identical references, and their description is omitted or simplified.

The comparator 21 outputs "1", for example, when the output of the amplifier 13 is larger than the comparison voltage, and outputs "0" when the comparison voltage is equal to or smaller than the comparison voltage. Thus, the comparator 21 compares the voltage across the photodiode 1 which has been amplified by the amplifier 13 with the comparison voltage, and outputs its comparison result as a digital signal.

The reset circuit 16 monitors the output of the comparator 21, and turns on the switch 17 to reset the electric charges of the photodiode 1 when the reset circuit 16 detects that the voltage across the amplifier 13 decreases down to the comparison voltage (in the above-mentioned example, when the reset circuit 16 detects that the output changes over from "1" to "0").

A period of time during which the voltage across the photodiode 1 (amplified by the amplifier 13, the same is applied below) reaches the comparison voltage from the reference voltage becomes shorter as the light intensity is larger. As a result, an interval during which the reset circuit 16 executes reset is shortened.

A clock 72 generates a clock pulse that is a pulse signal having regular intervals, and inputs the clock pulse to a counter circuit 71.

A pulse width of the clock pulse is set to be sufficiently shorter compared with a period of time during which the voltage across the photodiode 1 reaches the comparison voltage from the reference voltage so that the period of time may be measured.

The clock 72 functions as clock signal generating means that generates the clock signal.

The counter circuit 71 inputs the digital signal indicative of the comparison result from the comparator 21, and also inputs the clock pulse from the clock 72.

Then, with the use of those signals, the counter circuit 71 counts the number of pulses of clock pulses in a period of time during which the voltage across the photodiode 1 decreases from the reference voltage to the comparison voltage, and outputs the count value.

Since a time period until the output of the photodiode 1 reaches the comparison voltage is inverse-proportional to the light intensity, a larger light intensity makes the count value smaller, thereby enabling acquisition of the count value corresponding to the light intensity.

As described above, the counter circuit 71 functions as count value generating means that associates the amount of electric charges accumulated in the photodiode 1 with the clock signal generated by the clock 72 to generate a count value corresponding to the amount of accumulated electric charges, and also functions as count value output means that outputs the generated count value.

Further, the counter circuit 71 generates the number of clock signals that have been generated until the accumulated electric charges changes from an initial value to a given value as the count value.

FIGS. 13A to 13D are timing charts of the digitizing circuit 77.

The output of the photodiode 1 (FIG. 13A) is reset to the reference voltage according to the reset signal (FIG. 13C) of the reset circuit 16, and thereafter is decreased at higher rate as the light intensity is larger until the output reaches the comparison voltage.

The comparison result (FIG. 13B) output by the comparator 21 outputs "0" when the voltage across the photodiode 1 reaches the comparison voltage from the reference voltage, with the result that the reset circuit 16 outputs the reset signal (FIG. 13C).

The counter circuit 71 measures the clock pulse that is generated by the clock 72 during a period when the comparison result of the comparator 21 is "1" (clock pulse measurement period of FIG. 13D), and outputs the measurement value.

In the above-mentioned manner, in the digitizing circuit 77, the measured clock pulse becomes smaller as the light intensity is larger, and hence the number of pulses corresponding to the light intensity is obtained.

FIG. 12B is a diagram for describing a configuration of a digital output photodetection circuit 75 according to this embodiment.

The digital output photodetection circuit 75 includes the digitizing circuit 77 that digitizes the output of the photodiode 1, and a digitizing circuit 78 that digitizes the output of the photodiode 2. A configuration of the digitizing circuit 78 is identical with that of the digitizing circuit 77.

A difference operation unit 73 receives the outputs of the photodiodes 1 and 2 which have been converted into the digital values from the digitizing circuits 77 and 78, calculates a difference therebetween through digital processing, and outputs the calculated difference as a digital value.

As described above, the difference operation unit 73 functions as count value acquiring means for acquiring a first count value corresponding to the amount of electric charges accumulated in the first light receiving element (photodiode 1), and a second count value corresponding to the amount of electric charges accumulated in the second light receiving element (photodiode 2) having the spectral characteristic different from that of the first light receiving element. The difference operation unit 73 also functions as difference operation means for calculating a difference between the acquired first count value and second count value in a digital manner, and also functions as difference output means that outputs the calculated difference as the digital value.

In the above-mentioned manner, in the digital output photodetection circuit 75, the difference between the outputs of the photodiodes 1 and 2 may be digitized with a simple configuration using the counter circuit 71 and the clock 72 even without using operation logic such as an A/D converter.

### Second Embodiment of Digital Output Photodetection Circuit

In this embodiment, the number of resetting the photodiodes 1 and 2 is measured within a period of a reference pulse to thereby digitize the light intensity.

The amount of electric charges that have been accumulated within a period of the reference pulse is measured by each accumulation amount unit, thereby associating the amount of accumulated electric charges with the generated clock signals.

FIG. 14A is a diagram illustrating a configuration of a digitizing circuit 77a that digitizes the output of the photodiode 1.

The configuration of the digitizing circuit 77a according to this embodiment is identical with that of the digitizing circuit 77 described in the first embodiment, and thus the corresponding elements are denoted by identical reference numerals, and their description is omitted or simplified.

The configurations of the comparator 21 and the reset circuit 16 are identical with those of FIG. 12A.

A clock 72a generates a reference pulse that is a pulse having regular intervals, and inputs the reference pulse to the counter circuit 71 a.

A pulse width of the reference pulse is set to be sufficiently longer as compared with a period of time during which the reset circuit 16 resets the photodiode 1 so that the number of resetting when the voltage across the photodiode 1 reaches the comparison voltage from the reference voltage may be measured.

When the reference pulse width is set to be longer than the cycle of flicker (about 200 [ms] in fluorescent lamp), it is possible to reduce the measurement error caused by flicker.

The counter 71 a inputs the digital signal indicative of the comparison result from the comparator 21, and also inputs the reference pulse from the clock 72a.

Then, with the use of those signal and pulse, the counter circuit 71 a counts the number of resetting by the reset circuit 16 when the voltage across the photodiode 1 decreases from the reference voltage to the comparison voltage during the reference pulse, that is, the number of times when the output of the photodiode 1 reaches the comparison voltage within the reference pulse, and outputs the counted number of times.

The number of times when the output of the photodiode 1 reaches the comparison voltage within a given period of time is in proportion to the light intensity, and hence the number of times is indicative of the light intensity.

In the digitizing circuit 77 according to the first embodiment, the number of outputting becomes smaller as the light intensity is larger. On the other hand, in the digitizing circuit 77a according to this embodiment, the number of outputting becomes larger as the light intensity is larger. As a result, the digitizing circuit 77a is more suited for the feeling of a user who uses the sensor.

As described above, the digitizing circuit 77a includes reset means (reset circuit 16, switch 17, etc.) that resets the accumulated electric charges to an initial value every time the amount of electric charges accumulated in the photodiode 1 reaches a given amount, and the counter 71 a functions as count value generating means that generates the number of times the reset means resets during a given period of time measured by the clock signal as a count value.

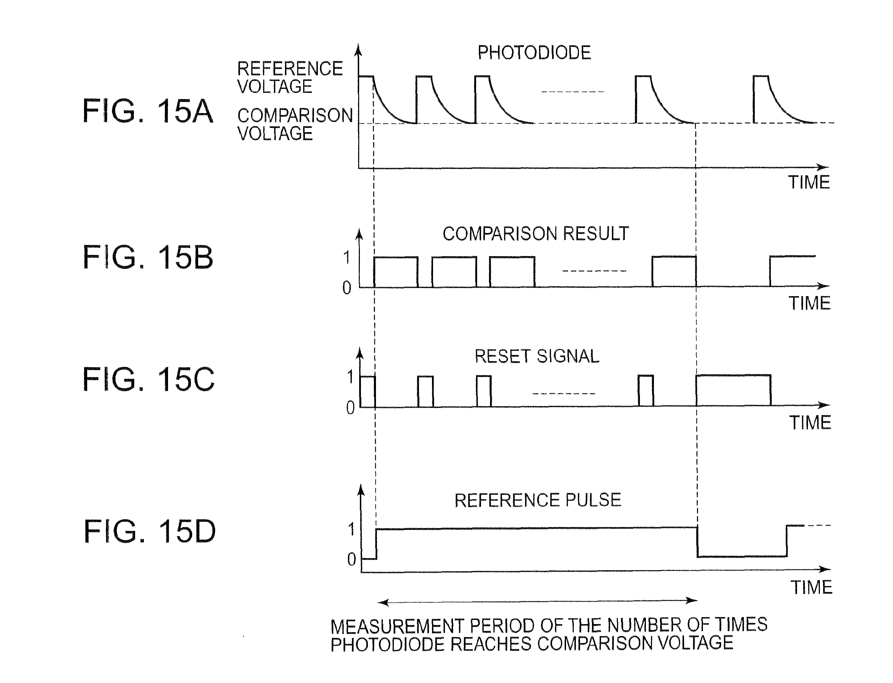

FIGS. 15A to 15D are timing charts of the digitizing circuit 77a according to the second embodiment.

The output of the photodiode 1 (FIG. 15A) is reset to the reference voltage according to the reset signal (FIG. 15C) of the reset circuit 16, and thereafter is decreased at higher rate as the light intensity is larger until the output of the photodiode 1 reaches the comparison voltage.

The comparison result (FIG. 15B) output by the comparator 21 outputs "0" when the voltage across the photodiode 1 reaches the comparison voltage from the reference voltage, with the result that the reset circuit 16 outputs the reset signal (FIG. 15C).

The counter circuit 71 a measures and outputs the number of times the voltage of the photodiode 1 reaches the comparison voltage, that is, the number of times the reset circuit 16 resets the photodiode 1, during a period when the reference pulse generated by the clock 72a is "1" (measurement period of number of times voltage of photodiode of FIG. 15D reaches comparison voltage).

In the above-mentioned manner, in the digitizing circuit 77a, the number of times of resetting of the photodiode 1 is increased more as the light intensity is larger, thereby obtaining the number of pulses according to the light intensity.

FIG. 14B is a diagram for describing the configuration of a digital output photodetection circuit 75a according to this embodiment.

The digital output photodetection circuit 75a includes a digitizing circuit 77a that digitizes the output of the photodiode 1, and a digitizing circuit 78a that digitizes the output of the photodiode 2. The configuration of the digitizing circuit 78a is identical with that of the digitizing circuit 77a.

The difference operation unit 73 receives the outputs of the photodiodes 1 and 2 which have been converted into the digital values from the digitizing circuits 77a and 78a, calculates a difference therebetween through digital processing, and outputs the calculated difference as a digital value.

In the above-mentioned manner, in the digital output photodetection circuit 75a, the difference between the outputs of the photodiodes 1 and 2 may be digitized with a simple configuration using the counter circuit 71 a and the clock 72a even without using operation logic such as an A/D converter.

Further, the digitizing circuit 77a according to this embodiment constitutes the digital output photodetection circuit including: a light receiving element that generates electric charges according to the received light; reset means for resetting the electric charges accumulated in the light receiving element to an initial value when the light receiving element accumulates a given amount of electric charges; and number-of-times output means for outputting the number of times of resetting of the light receiving element by the reset means during a given period of time.

The embodiment described above may obtain the following advantages.
(1) The amount of electric charges accumulated in the photodiodes 1 and 2 may be associated with the clock. As a result, the count value corresponding to the amount of the electric charges may be generated to digitize the amount of the electric charges accumulated in the photodiodes 1 and 2.
(2) Digitalization may be executed by using simple elements such as the counter circuit 71 or the clock 72, and hence it is unnecessary to use the large-scaled logic such as an A/D converter.
(3) It is unnecessary to use the A/D converter, and hence the IC chip may be downsized.
(4) A period of time until the voltage of the light receiving element reaches the reference voltage may be measured by the clock pulse, and the number of pulses may be output as the digital value.
(5) The number of times the voltage of the light receiving element reaches the reference voltage within a given period of time produced by the reference pulse may be measured and output as the digital value.

In the above, various embodiments and modifications have been described, and may provide the following configurations.
(A) The embodiment of the photodetector may obtain the following configurations.
   (First Configuration) A photodetector including: a first light receiving element that generates electric charges according to received light; a second light receiving element that generates electric charges according to the received light and has a spectral characteristic different from a spectral characteristic of the first light receiving element; accumulating means for accumulating the generated electric charges in the first light receiving element and the second light receiving element; difference acquiring means for acquiring a difference between the electric charges accumulated in the first light receiving element and the electric charges accumulated in the second light receiving element; and difference output means for outputting the acquired difference.
   (Second Configuration) The photodetector according to the first configuration, in which the accumulating means electrically bring given electrodes of the first light receiving element and the second light receiving element into open ends to accumulate the electric charges.
   (Third Configuration) The photodetector according to the second configuration, in which the given electrodes of the first light receiving element and the second light receiving element are connected to a constant voltage source for resetting the electric charges accumulated in the first light receiving element and the second light receiving element through a given switch, and in which the accumulating means turns off the given switch to electrically bring the given electrodes into the open ends.
   (Fourth Configuration) The photodetector according to the second or third configuration, in which the difference acquiring means acquires the difference between the accumulated electric charges by a voltage difference between the given electrodes of the first light receiving element and the second light receiving element.
   (Fifth Configuration) The photodetector according to the first configuration, further including reset means for resetting the electric charges accumulated in the first light receiving element and the second light receiving element by connecting given electrodes of the first light receiving element and the second light receiving element to a given constant voltage source.
   (Sixth Configuration) The photodetector according to any one of the first to fifth configurations, further including changing means for changing a period of time during which the accumulating means accumulates the electric charges according to a light intensity.
   (Seventh Configuration) The photodetector according to any one of the first to sixth configurations, further including driving means for driving the difference acquiring means at timing when the difference output means outputs the difference.
   (Eighth Configuration) The photodetector according to any one of the first to seventh configurations, further including reducing means for reducing a variation occurring in the difference output from the difference output means due to a variation of the light intensity of light generated by the light source.
   (Ninth Configuration) An image display device including: the photodetector according to any one of the first to eighth configurations; image display means for displaying an image; brightness determining means for determining brightness of an outside world with the aid of an output of the photodetector; and illuminance adjusting means for adjusting illuminance of the image display means according to the determined brightness.
(B) The first embodiment of the photodetection semiconductor device provides the following configurations.
   (First Configuration) A photodetection semiconductor device, including: a first light receiving element; a second light receiving element having a spectral characteristic different from a spectral characteristic of the first light receiving element; and an electromagnetic wave shield layer that transmits light and has conductivity, in which a light intensity is detected by using a difference between electric charges accumulated in the first light receiving element and electric charges accumulated in the second light receiving element, in which the first light receiving element includes: a semiconductor substrate formed of a first conductivity type semiconductor; and a first conductive layer having a second conductivity type semiconductor formed with a given depth from a surface of the semiconductor substrate, in which the second light receiving element includes: the semiconductor substrate; and a second conductive layer having the second conductivity type semiconductor formed with a depth larger than the given depth from the surface of the semiconductor substrate, and in which the electromagnetic wave shield layer is formed on a surface of the first conductive layer and a surface of the second conductive layer.
   (Second Configuration) The photodetection semiconductor device according to the first configuration, in which the electromagnetic wave shield layer is formed of the first conductivity type semiconductor.
   (Third Configuration) The photodetection semiconductor device according to the first configuration, in which the electromagnetic wave shield layer is formed of polysilicon.
   (Fourth Configuration) A photodetector, including: accumulating means, which is connected to the photodetection semiconductor device according to the first, second, or third configuration, the accumulating means being for accumulating, in the first light receiving element and the second light receiving element of the photodetection semiconductor device, the electric charges generated in the first light receiving element and the second light receiving element; difference acquiring means for acquiring a difference between the accumulated electric charges; and difference output means for outputting the acquired difference.
   (Fifth Configuration) An image display device, including: the photodetector according to the fourth configuration; image display means for displaying an image; lightness determining means for determining lightness of an outside with the aid of an output of the photodetector; and brightness adjusting means for adjusting brightness of the image display means according to the determined brightness.
(C) The second embodiment of the photodetection semiconductor device provides the following configurations.
   (First Configuration) A photodetection semiconductor device, including: a first light receiving element; a second light receiving element; a first filter layer having light transmittance depending on a wavelength of light; and a second filter layer having dependency in light transmittance different from dependency of the first filter layer, in which a light intensity is detected by using a difference between electric charges accumulated in the first light receiving element and electric charges accumulated in the second light receiving element, in which the first light receiving element includes: a semiconductor substrate formed of a first conductivity type semiconductor; and a first conductive layer having a second conductivity type semiconductor formed with a given depth from a surface of the semiconductor substrate, in which the second light receiving element includes: the semiconductor substrate; and a second conductive layer having the second conductivity type semiconductor formed with the given depth from the surface of the semiconductor substrate, in which the first filter layer is formed on a surface of the first conductive layer, and in which the second filter layer is one of formed on a surface of the second conductive layer and prevented from being formed on the surface of the second conductive layer.
   (Second Configuration) The photodetection semiconductor device according to the first configuration, in which the first filter layer and the second filter layer have conductivity.
   (Third Configuration) The photodetection semiconductor device according to the first or second configuration, in which the first filter layer and the second filter layer are formed of the first conductivity type semiconductor.
   (Fourth Configuration) The photodetection semiconductor device according to the first or second configuration, in which the first filter layer and the second filter layer are formed of polysilicon.
   (Fifth Configuration) A photodetector, including: accumulating means, which is connected to the photodetection semiconductor device according to any one of the first to fourth configurations, the accumulating means being for accumulating, in the first light receiving element and the second light receiving element of the photodetection semiconductor device, the generated electric charges; difference acquiring means for acquiring a difference between the accumulated electric charges; and difference output means for outputting the acquired difference.
   (Sixth Configuration) An image display device, including: the photodetector according to the fifth configuration; image display means for displaying an image; brightness determining means for determining brightness of an outside world with the aid of an output of the photodetector; and luminance adjusting means for adjusting luminance of the image display means according to the determined brightness.
(D) The embodiment of the digital output photodetection circuit provides the following configurations.
   (First Configuration) A digital output photodetection circuit, including: a first light receiving element; a second light receiving element, the first light receiving element and the second light receiving element generating electric charges according to received light; accumulating means for accumulating the electric charges generated in the first light receiving element and the second light receiving element; clock signal generating means for generating a clock signal; count value generating means for generating a count value corresponding to an amount of the accumulated electric charges by associating the amount of the accumulated electric charges with the generated clock signal; and count value output means for outputting the generated count value.
   (Second Configuration) The digital output photodetection circuit according to the first configuration, in which the count value generating means generates the number of clock signals which are generated until the accumulated electric charges changes to a given value from an initial value as the count value.
   (Third Configuration) The digital output photodetection circuit according to the first configuration, further including reset means for resetting the accumulated electric charges to an initial value every time the amount of the accumulated electric charges reaches a given amount, in which the count value generating means generates the number of times of resetting by the reset means during a given period of time measured by the clock signal as the count value.
   (Fourth Configuration) A photodetector using the digital output photodetection circuit according to any one of the first, second, or third configuration, the photodetector including: count value acquiring means for acquiring a first count value corresponding to an amount of electric charges accumulated in the first light receiving element, and a second count value corresponding to an amount of electric charges accumulated in the second light receiving element having a spectral characteristic different from a spectral characteristic of the first light receiving element; difference operation means for calculating a difference between the acquired first count value and the acquired second count value in a digital manner; and a difference output means for outputting the calculated difference as a digital value.
   (Fifth Configuration) An image display device, including: the photodetector according to the fourth configuration; image display means for displaying an image; brightness determining means for determining brightness of an outside world with the aid of an output of the digital output photodetection circuit; and luminance adjusting means for adjusting luminance of the image display means according to the determined brightness.

The foregoing description has been given by way of example only and it will be appreciated by a person skilled in the art that modifications can be made without departing from the scope of the present invention.

## Claims

1. A photodetection semiconductor device (6a, 6b), comprising:
a first light receiving element (2) having a semiconductor substrate (3) of a first conductivity type and a first conductive layer (5) formed of a second conductivity type semiconductor disposed with a given depth from a surface of the semiconductor substrate;
a second light receiving element (1) having the semiconductor substrate (3) and a second conductive layer (4) formed of the second conductivity type semiconductor disposed with a depth deeper than the given depth from the surface of the semiconductor substrate and having a spectral characteristic different from a spectral characteristic of the first light receiving element; and
an electromagnetic wave shield layer(51, 57) transmitting light and having a conductivity disposed on a surface of the first conductive layer and a surface of the second conductive layer,
wherein a light intensity is detected from a difference between electric charge accumulated in the first light receiving element and electric charge accumulated in the second light receiving element.

2. A photodetection semiconductor device (6a) according to claim 1, wherein the electromagnetic wave shield layer (51) is formed of the first conductivity type semiconductor.

3. A photodetection semiconductor device (6b) according to claim 1, wherein the electromagnetic wave shield layer (57) is formed of polysilicon.

4. A photodetector, comprising:
accumulating means (16, 17, 18) for accumulating electric charge generated respectively in the first light receiving element and the second light receiving element of the photodetection semiconductor device in each of them and connected to the photodetection semiconductor device according to any one of the preceding claims;
difference acquiring means (15) for acquiring a difference between the accumulated electric charges; and
difference output means for sending the acquired difference.

5. An image display device, comprising:
the photodetector according to claim 4;
image display means for displaying an image;
light determining means for determining outside light with an aid of an output from the photodetector; and
brightness adjusting means for adjusting brightness of the image display means according to the determined light.
